(19) Europäisches Patentamt
European Patent Office
Office européen des brevets

(11) **EP 2 224 271 A2**

## (12) EUROPEAN PATENT APPLICATION

(43) Date of publication:
**01.09.2010 Bulletin 2010/35**

(51) Int Cl.:
***G02B 6/42*** *(2006.01)*

(21) Application number: **10154123.3**

(22) Date of filing: **19.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **27.02.2009 JP 2009047194**

(71) Applicant: Omron Corporation
**Kyoto-shi, Kyoto 600-8530 (JP)**

(72) Inventors:
• **Tanaka, Junichi**
  **Kyoto 600-8530 (JP)**
• **Sameshima, Hiroshi**
  **Kyoto 600-8530 (JP)**
• **Yasuda, Naru**
  **Kyoto 600-8530 (JP)**
• **Hosokawa, Hayami**
  **Kyoto 600-8530 (JP)**

(74) Representative: **Giovannini, Francesca et al**
**Osha Liang**
**32, avenue de l'Opéra**
**75002 Paris (FR)**

(54) **Light transmission module, electronic device, and manufacturing method of light transmission module**

(57) This invention reduces the distance between a light transmission path (2) and an optical element (3), and suppresses the optical loss in the optical coupling between the light transmission path (2) and optical element (3). A light transmission module (1) includes a light transmission path (2) for transmitting light; an optical element (3) including a light emitting and receiving surface that optically couples with the light transmitted by the light transmission path (2), and including a light emitting and receiving point (3a) with a function of photoelectric conversion and an electrode pad (3b) formed on the light emitting and receiving surface; a substrate (6) supporting the light emitting and receiving element and an electricalwiring (5); a bonding wiring (7) for electrically connecting the electrode pad (3b) and the electrical wiring (5); and a sealing resin portion (8) for sealing the optical element (3). The electrical wiring (5) and the electrode pad (3b) are reverse wire-bonded by the bonding wiring (7); and the sealing resin portion (8) includes an inclined part (8a) where a liquid sealing resin material is raised and solidified along a side wall of the optical element (3) by surface tension, and a flat part (8b) where the liquid sealing resin material is spread in parallel and solidified along the light emitting and receiving surface, the inclined part (8a) and the flat part (8b) being coupled together.

FIG. 1

**Description**

BACKGROUND OF THE INVENTION

1. TECHNICAL FIELD

The present invention relates to a light transmission module, an electronic device comprising the light transmission module, and a manufacturing method of the light transmission module.

2. RELATED ART

In recent years, optical communication network enabling large capacity data communication at high speed is expanding. The optical communication network is assumed to be mounted on a consumer device in the future. An electrical input/output optical data transmission cable (optical cable) capable of being used as the present electrical cables is desired for the application of large capacity data transfer at higher speed, noise countermeasures, and data transmission between substrates in the device. In view of flexibility, a film light guide is desirably used for the optical cable.

The light guide is formed by a core having a large index of refraction and a clad having a small index of refraction arranged in contact with the periphery of the core, and propagates the light signal entered to the core while repeating total-reflection at the boundary of the core and the clad. The film light guide has flexibility since the core and the clad are made of polymeric material.

The light transmission module in which the film light guide having flexibility is used as an optical cable generally includes the following members. In other words, the light transmission module includes a photoelectric conversion element (light emitting and receiving element), which optically couples with the light guide, a substrate with an electrical wiring connected to the photoelectric element, and an electrical connection unit for electrically connecting the electrical wiring and the photoelectrical conversion element. The light emitting and receiving element is an element converting the electrical signal to an optical signal and emits the same, and receiving the optical signal and converting the same to an electrical signal.

Wire bonding is generally used to electrically connect the semiconductor element and the electrical wiring. For instance, Japanese Unexamined Patent Publication No. 2004-6689 (published on January 8, 2004) discloses a method of wire-bonding a fingerprint sensor die to an external circuit. Japanese Unexamined Patent Publication No. 2005-101249 (published on April 14, 2005) describes a general wire bonding method.

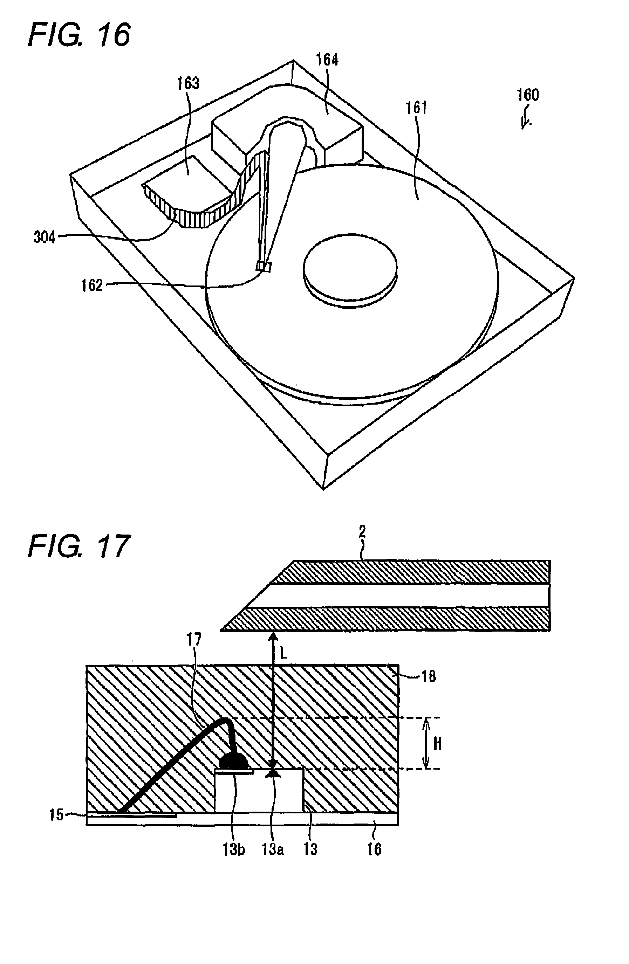

Fig. 17 is a cross-sectional view showing a schematic configuration of a conventional light transmission module that uses wire bonding for the electrical connection unit for electrically connecting the electrical wiring and the photoelectric conversion element.

As shown in the figure, a light emitting and receiving element 13 including a light emitting and receiving point 13a for optically coupling with a film light guide 2 is mounted on a substrate 16. An electrode pad 13b for electrically connecting with a substrate wiring 15 formed on the substrate 16 is formed on an upper surface of the light emitting and receiving element 13. The electrode pad 13a and the substrate wiring 15 are electrically connected through wire bonding by a bonding wiring 17. In the conventional light transmission module, a sealing resin portion 18 is formed to seal and protect the light emitting and receiving element 3 and the bonding wiring 17. The sealing resin portion 18 is made of translucent resin, and is formed to completely cover the light emitting and receiving element 13 and the bonding wiring 17, and so that the surface facing the film light guide 2 is flat.

Another example of the configuration of the light transmission module includes a light transmission module disclosed in Japanese Unexamined Patent Publication No. 2003-66282 (published on March 5, 2003).

SUMMARY

When using a light transmission path in a small and thin device, for example, lower power consumption of the light transmission module and lower height of the module are demanded. To respond to such demand, reduction in the optical coupling loss of the light transmission path and a light emitting and receiving element is desired. However, in the conventional light transmission module described above, there is a limit to bringing the light emitting and receiving element and the light transmission path close, and the distance between the light emitting and receiving point and the light transmission path becomes long. As a result, in the conventional light transmission module, the spot diameter of the light entering from the light emitting and receiving element to the light transmission path becomes large and the optical coupling loss becomes large. The problems of the conventional light transmission module will be described in detail below.

When electrically connecting the substrate wiring 15 and the electrode pad 13b through wire bonding as shown in Fig. 17, a high-low difference is formed between the forming surface of the electrode pad 13b and the forming surface of the substrate wiring 15, and thus the bonding wiring 17 becomes a loop structure. In wire bonding, the end of the bonding wiring 17 held in a capillary is first formed to a ball-shaped structure through discharge of high voltage, and then pressurized to bond to the electrode pad 13b. The bonding wiring 17 is then pulled out in the direction of the substrate wiring 15, and one part of the bonding wiring 17 and the substrate wiring 15 are bonded. Thus, the bonding wiring 17 has a loop shape in which a bent portion is arranged on an electrode pad side. The sealing resin portion 18 is formed to completely cover the bonding wiring 17 and the light emitting and receiving element 13.

Therefore, a thickness of the sealing resin portion 18 that covers the light emitting and receiving element 13 needs to be a thickness of greater than or equal to a total with a loop height of the bonding wiring to form the sealing resin portion 18 so as to form a gap with a film light guide 2. Thus, an optical coupling length L between the film light guide 12 and the light emitting and receiving element 13 is set to a distance greater than a loop height H of the bonding wiring, and the film light guide and the light emitting and receiving element become difficult to bring close. If the optical coupling length L of the light emitting and receiving element 13 and the film light guide 2 becomes long, the spot diameter at which a beam from the light emitting and receiving point 13a irradiates the film light guide 2 becomes wide and the optical loss becomes large.

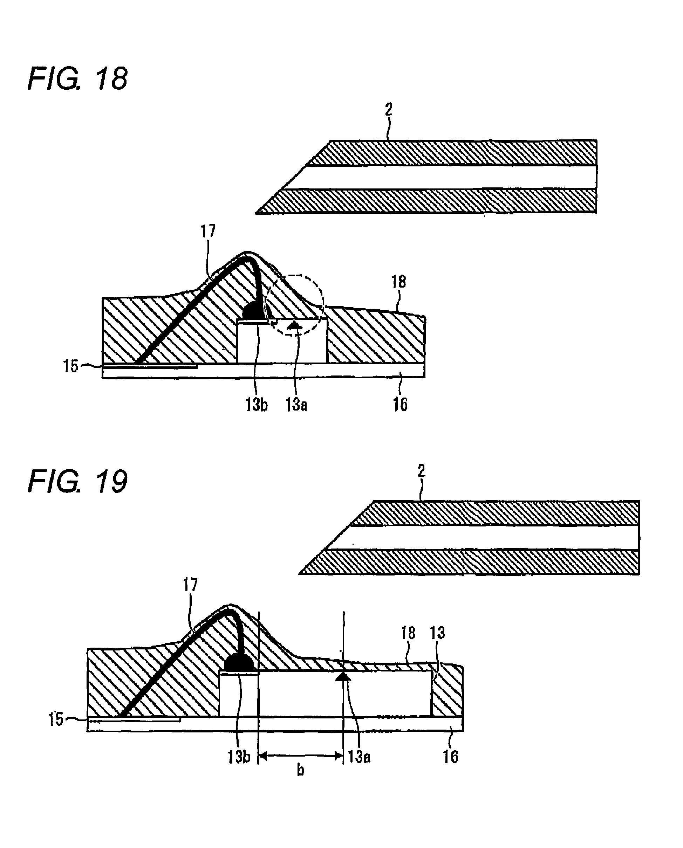

A configuration shown in Fig. 18 is considered to reduce an optical coupling distance between the film light guide 2 and the light emitting and receiving element 3. In other words, the sealing resin portion 18 is configured to cover at least the loop shape of the bonding wiring 17, and the thickness of the sealing resin portion 18 for covering the light emitting and receiving element 13 is made small. However, in the configuration shown in Fig. 18, a sealing boundary of the sealing resin portion 18 that covers the light emitting and receiving point 18 is not a flat surface but an inclined surface. Thus, the light path length of the light transmitted between the light emitting and receiving element 13 and the film light guide 2 increases by the influence of refraction of light at the sealing boundary, and the optical loss increases.

Furthermore, a configuration shown in Fig. 19 is considered to have the sealing boundary of the sealing resin portion 8 flat in the configuration shown in Fig. 18. In other words, consideration is made in designing the light emitting and receiving element 13 so that the distance b between the light emitting and receiving point 13a and the electrode pad 13b becomes large. In the configuration shown in Fig. 19, the sealing boundary of the sealing resin portion 18 that covers the light emitting and receiving point 18 becomes flat and the optical coupling distance between the film light guide 2 and the light emitting and receiving element 3 becomes small. However, the size of the light emitting and receiving element 13 needs to be designed large, and hence increase in cost is inevitable. The occupying area of the entire light transmission module also increases.

The present invention has been devised to solve the problems described above, and an object thereof is to realize a light transmission module, an electronic device comprising the light transmission module, and a manufacturing method of the light transmission module in which the distance between the light guide and the light emitting and receiving element can be designed small, and the optical loss in the optical coupling between the light guide and the light emitting and receiving element can be suppressed.

In accordance with one aspect of the present invention, the present invention provides a light transmission module including: a light transmission path for transmitting light; an optical element including a light emitting and receiving surface for emitting or receiving an optical signal transmitted by the light transmission path, and including a light emitting and receiving point with a function of photoelectric conversion and an electrode pad formed on the light emitting and receiving surface; a substrate supporting the optical element and an electrical wiring; a bonding wiring for electrically connecting the electrode pad and the electrical wiring; and a sealing portion for sealing the optical element; wherein the electrical wiring and the electrode pad are reverse wire-bonded by the bonding wiring; and the sealing portion includes an inclined part where a liquid sealing resin material is raised and solidified along a side wall of the optical element by surface tension, and a flat part where the liquid sealing resin material is spread in parallel and solidified along the light emitting and receiving surface, the inclined part and the flat part being coupled together.

According to the above configuration, the electrical wiring and the electrode pad are reverse wire-bonded by the bonding wiring, and thus the height of the optical element and the loop height of the bonding wiring cancel each other out. In other words, the loop height of the bonding wiring does not need to be taken into consideration in the setting of the distance between the light transmission path and the light emitting and receiving point. Thus, the light transmission path and the optical element can be brought close, and lower height of the light transmission module can be realized.

According to the above configuration, the inclined part is configured by a solidified object in which the liquid sealing resin material is raised and solidified along the side wall of the optical element by surface tension. The flat part is configured by a solidified object in which the liquid sealing resin material is spread in parallel and solidified along the light emitting and receiving surface. The inclined part and the flat part are coupled. Thus, when the liquid sealing resin material raised along the side wall of the optical element by surface tension and the liquid sealing resin material spread in parallel along the light emitting and receiving surface contact with each other, the liquid sealing resin material spread in parallel along the light emitting and receiving surface flows into the substrate over the side wall of the optical element. As a result, the liquid amount of the liquid sealing resin material spread in parallel along the light emitting and receiving surface can be minimized, and a thickness of the flat part where the liquid sealing resin material solidified becomes thin. The light transmission path and the optical element thus can be sufficiently brought close.

Furthermore, according to the above configuration, the flat part is parallel to the light emitting and receiving surface and is not inclined when the distance between the light transmission path and the optical element is brought close, and hence the increase in the light path length by refraction at the sealing boundary of the light exit from the light emitting and receiving point can be avoided. As a result, lower height can be realized, and a light transmission module in which the optical coupling loss (optical loss) between the light transmission path and the optical element is small can be realized.

The sealing portion in the light transmission module of the present invention merely needs to have a configuration of sealing the optical element, and the bonding wiring merely needs to cover at least the contact with the electrical wiring and the electrode pad.

That is, in the light transmission module of the present invention, the bonding wiring has a loop shape in which a bent portion is arranged on the electrical wiring side; and the sealing portion is formed to cover a respective contact with the electrical wiring and the electrode pad in the bonding wiring and to expose the portion of the loop shape.

According to the above configuration, the bonding wiring has a loop shape in which the bent portion is arranged on the electrical wiring side, and the sealing portion is formed to cover the contact with the electrical wiring and the electrode pad in the wire bonding and to expose the loop-shaped portion, where the sealing portion existing between the bonding wiring and the light transmission path is eliminated. According to the above configuration, the light transmission path and the bonding wiring can be brought close, and the distance between the light transmission path and the optical can be reduced compared to the conventional light transmission module by the amount the sealing portion is eliminated.

In the light transmission module of the present invention, the light transmission path is a film light guide in which at least one end face is diagonally processed; the bonding wiring is arranged avoiding the light transmission path in plan view; and a distal end in the light transmitting direction of the light transmission path is arranged between the contact with the electrode pad in the bonding wiring and the light emitting and receiving point.

According to the above configuration, the bonding wiring is arranged avoiding the light transmission path and the distal end in the light transmitting direction in the light transmission path is arranged between the contact with the electrode pad in the bonding wiring and the light emitting and receiving point in plan view, and thus the interference of the bonding wiring with the light transmission path can be reliably prevented.

In accordance with another aspect of the present invention, the present invention provides an electronic device including the light transmission module, wherein the optical element serving as a light emitting element and the optical element serving as a light receiving element are arranged at a position of emitting light and a position of receiving light, respectively, with respect to the optical signal transmitted by the light transmission path; and the light transmission module further includes an electrical connecting portion, electrically connected with the electrical wiring, for electrically connecting with an external wiring.

In the electronic device of the present invention, the electrical connecting portion at both ends in the light transmission path is connected to a device substrate inside the electronic device, respectively.

Therefore, the optical data transmission between the device substrates in the electronic device can be performed by simply electrically connecting the light transmission module to between the device substrates. Furthermore, the electronic device can be miniaturized since the data transmission can be carried out with the light transmission module mounted.

In the electronic device of the present invention, the optical element and the end face of the light transmission path in the light transmission module are arranged in a housing of the electronic device.

Therefore, the electronic device can be further miniaturized since the substrate for mounting the optical element and the end face of the light transmission path does not need to be arranged in the housing.

In the electronic of the present invention, a hinge portion is arranged; and the light transmission module is arranged at the hinge portion.

Therefore, the noise that is easily generated at the bent portion can be reduced, and the data transmission between the device substrates inside the electronic device with a hinge can be reliably and efficiently carried out. Furthermore, since the light transmission module is small and has flexibility, and thus can be mounted after incorporating the hinge to the electronic device with the hinge, an electronic device having high productivity can be realized.

In accordance with still another aspect of the present invention, a manufacturing method of a light transmission module including, a light transmission path for transmitting light; an optical element including a light emitting and receiving surface for emitting or receiving an optical signal transmitted by the light transmission path, and including a light emitting and receiving point with a function of photoelectric conversion and an electrode pad formed on the light emitting and receiving surface; a substrate supporting the optical element and an electrical wiring; a bonding wiring for electrically connecting the electrode pad and the electrical wiring; and a sealing portion for sealing the optical element; the method including the steps of: bonding step of reverse bonding the electrical wiring and the electrode pad by the bonding wiring; first dropping step of dropping a first liquid sealing resin material onto the light emitting and receiving surface of the optical element; and second dropping step of dropping a second liquid sealing resin material onto the surface of the substrate; wherein dropping is performed until the first liquid sealing resin material spread by surface tension with the light emitting and receiving surface and the second liquid sealing resin material raised along a side wall by surface tension with the side wall of the optical element contact in at least one step of the first or the second dropping step.

According to the above configuration, the light transmission path and the optical element can be brought close and a light transmission module having lower height can be manufactured since reverse wire bonding is carried out by the bonding wiring in the bonding step.

According to the above configuration, the dropping is performed until the first liquid sealing resin material spread by surface tension with the light emitting and receiving surface and the second liquid sealing resin material raised along a side wall by surface tension with the side wall of the optical element contact in at least one step of the first or the second dropping step, and thus the first liquid sealing resin material flows to the surface of the substrate over the side wall without retaining at the light emitting and receiving surface. The first liquid sealing resin material spreads in parallel to the light emitting and receiving surface at the minimum liquid amount when the flow of the first liquid sealing resin material to the substrate surface is stopped. The sealing portion that covers the light emitting and receiving surface is formed thin and flat by solidifying the first liquid sealing resin material spread on the light emitting and receiving surface and the second liquid sealing resin material on the substrate.

Therefore, according to the above configuration, the light transmission path and the optical element can be brought sufficiently close, lower height can be realized, and a manufacturing method of the light transmission module in which the optical coupling loss (optical loss) between the light transmission path and the optical element is small can be realized.

In the manufacturing method of the light transmission module of the present invention, in the first dropping step, the dropping is stopped at a time point the first liquid sealing resin material reached an edge of the optical element when seen from the light emitting and receiving surface side; and in the second dropping step, the dropping is stopped at a time point the second liquid sealing resin material raised along the side wall of the optical element contacts the first liquid sealing resin material.

As described above, the light transmission module of the present invention has a configuration in which the electrical wiring and the electrode pad are reverse wire-bonded by the bonding wiring, and the sealing portion includes an inclined part where the liquid sealing resin material is raised and solidified along the side wall of the optical element by surface tension and a flat part where the liquid sealing resin material is spread in parallel and solidified along the light emitting and receiving surface, the inclined part and the flat part being coupled together.

The electronic device of the present invention is an electronic device including the light transmission module, where the optical element serving as a light emitting element and the optical element serving as a light receiving element are arranged at a position of emitting light and a position of receiving light, respectively, with respect to the optical signal transmitted by the light transmission path, and the light transmission module further includes an electrical connecting portion, electrically connected with the electrical wiring, for electrically connecting with an external wiring.

The manufacturing method of the light transmission module of the present invention includes bonding step of reverse bonding the electrical wiring and the electrode pad by the bonding wiring; first dropping step of dropping a first liquid sealing resin material onto the light emitting and receiving surface of the optical element; and second dropping step of dropping a second liquid sealing resin material onto the surface of the substrate; wherein dropping is performed until the first liquid sealing resin material spread by surface tension with the light emitting and receiving surface and the second liquid sealing resin material raised along a side wall by surface tension with the side wall of the optical element contact in at least one step of the first or the second dropping step.

Therefore, the light transmission path and the optical element can be brought sufficiently close, lower height can be realized, and a manufacturing method of the light transmission module in which the optical coupling loss (optical loss) between the light transmission path and the optical element is small can be realized.

BRIEF DESCRIPTION OF THE DRAWINGS

Fig. 1 is a side view showing a schematic configuration of a light transmission module according to one embodiment of the present invention;
Fig. 2 is a schematic view for describing the way of thinking the estimation of the optical loss;
Fig. 3 is a table showing the result of estimating the optical loss based on the way of thinking of the estimation shown in Fig. 2 for the conventional light transmission module and the light transmission module of the present embodiment, and comparing the estimation;
Figs. 4A to 4F are cross-sectional views showing manufacturing procedures of the light transmission module of the present embodiment;
Fig. 5 is a cross-sectional view showing a schematic configuration of the light transmission module serving as a first variant;
Fig. 6 is a cross-sectional view showing a schematic configuration of the light transmission module serving as a second variant;
Fig. 7 is a cross-sectional view showing a schematic configuration of the light transmission module including the optical fiber for the light transmission path;
Fig. 8 is a cross-sectional view showing a schematic configuration of the light transmission module including the lens for the light transmission path;
Figs. 9A and 9B show the entire light transmission module using the optical wiring serving as a film light guide and the electrical wiring substrate, where Fig.

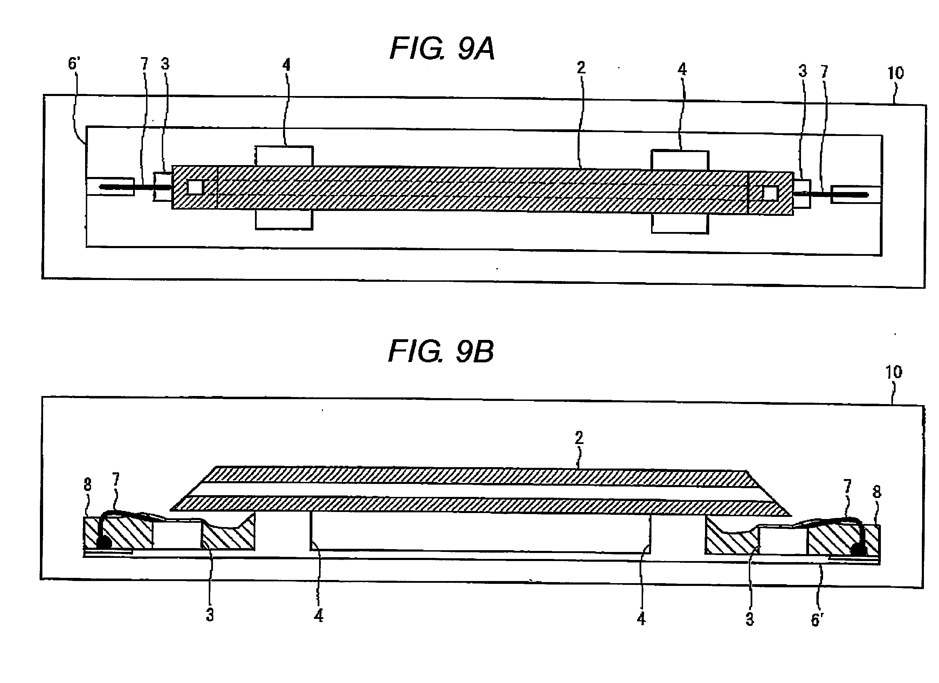

9A is a top view and Fig. 9B is a side cross-sectional view;

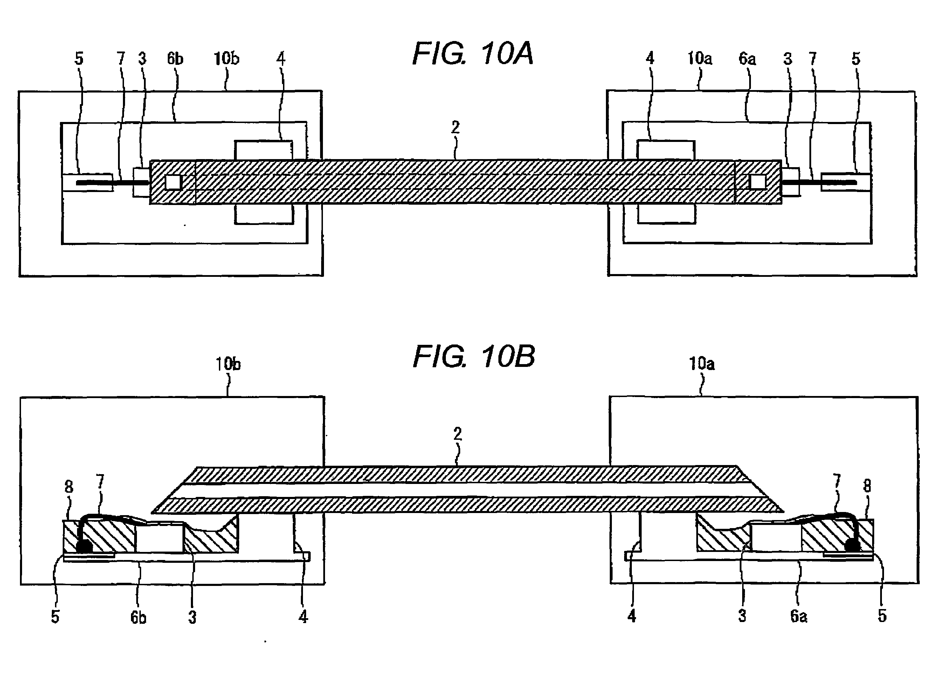

Figs. 10A and 10B show another example of the light transmission module for implementing the inter-substrate wiring, where Fig. 10A is a top view and Fig. 10B is a side cross-sectional view;

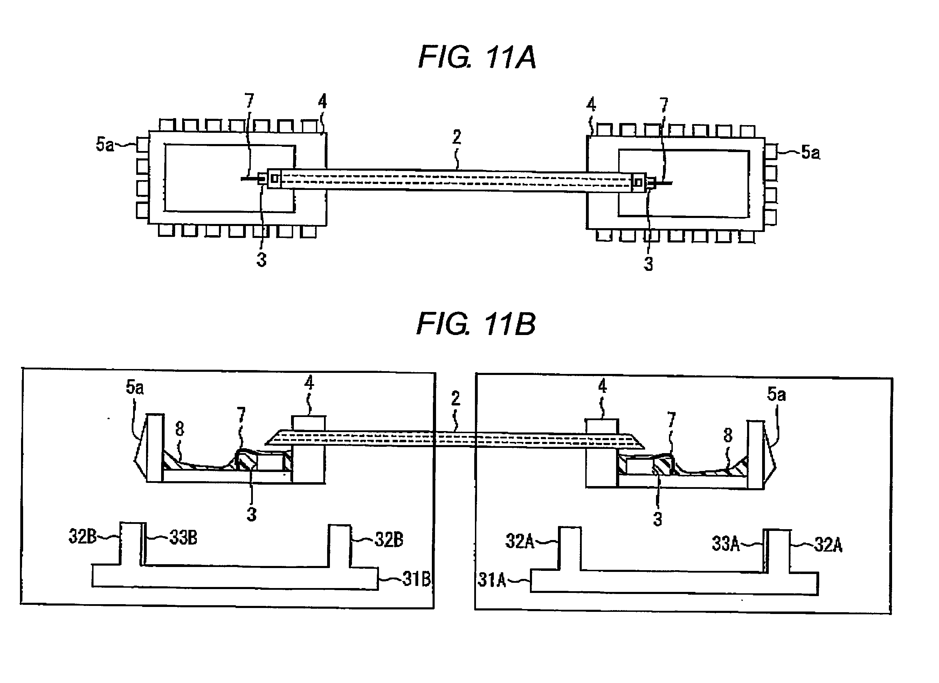

Figs. 11A and 11B show another further example of the light transmission module for implementing the inter-substrate wiring, where Fig. 11A is a top view and Fig. 11B is a side cross-sectional view;

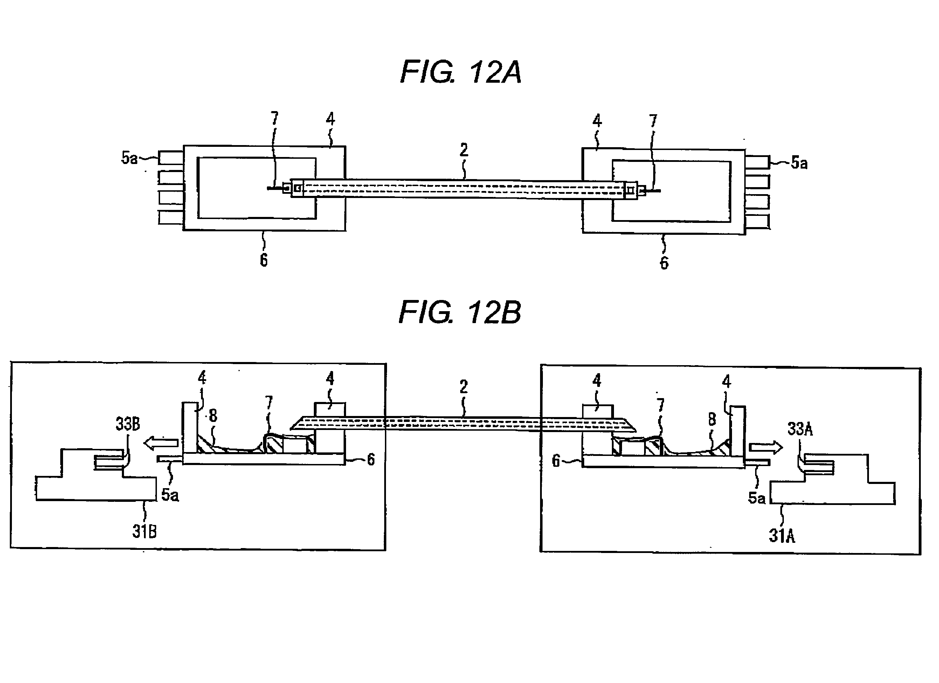

Fig. 12A is a plan view showing a schematic configuration of the light transmission module in which the electrical connecting portion is arranged in a shape projecting in the direction parallel to the surface of the substrate, and Fig. 12B is a side cross-sectional view thereof;

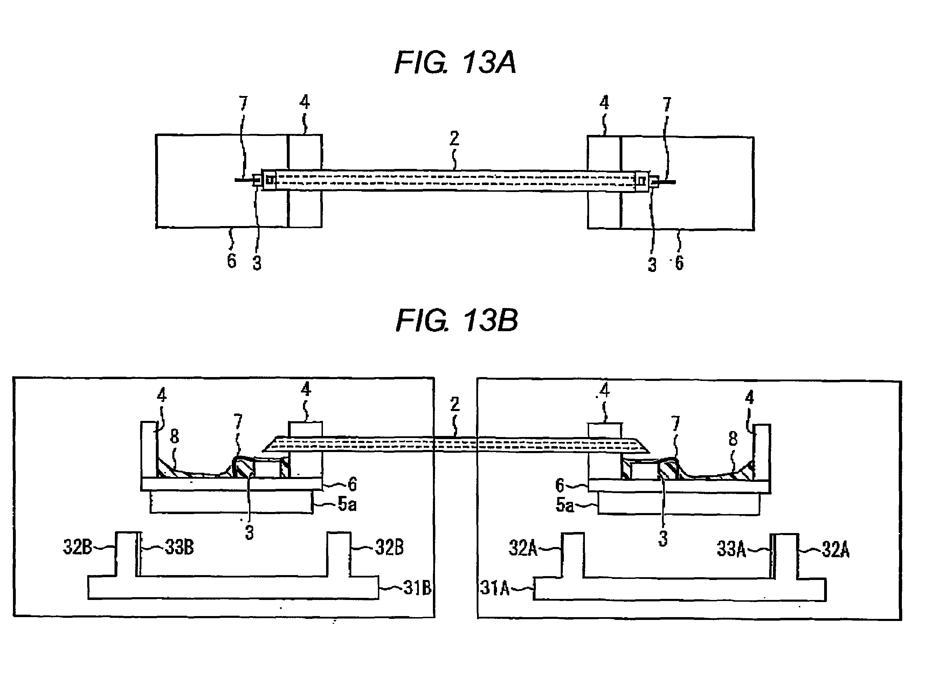

Fig. 13A is a plan view showing a schematic configuration of the light transmission module in which the electrical connecting portion serving as an electrical connector is arranged on a surface on the side opposite to a light emitting and receiving element of the substrate, and Fig. 13B is a side cross-sectional view thereof;

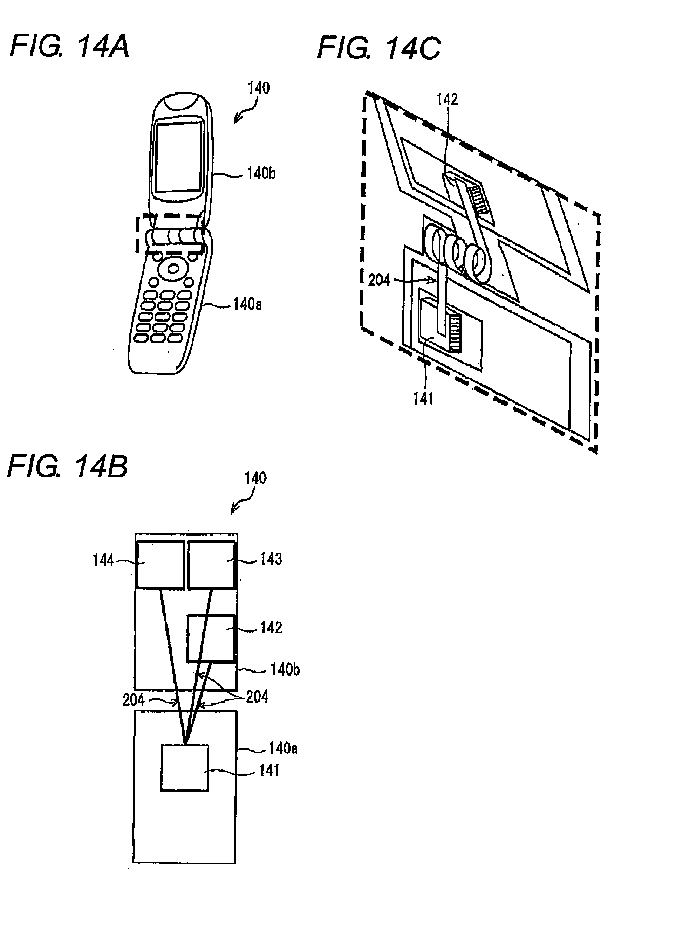

Fig. 14A is a perspective view showing an outer appearance of a foldable portable telephone including the light transmission module according to the present embodiment, Fig. 14B is a block diagram of a portion where the light transmission path is applied in the foldable portable telephone shown in Fig. 14A, and Fig. 14C is a perspective plan view of a hinge portion in the foldable portable telephone shown in Fig. 14A;

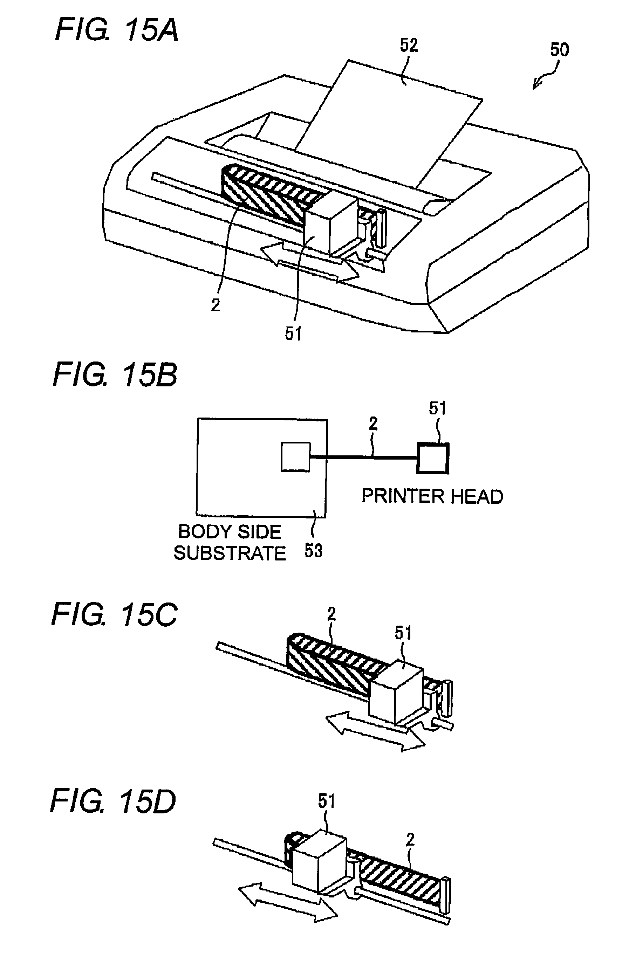

Fig. 15A is a perspective view showing an outer appearance of a printing device including the light transmission module according to the present embodiment, Fig. 15B is a block diagram showing the main parts of the printing device shown in Fig. 15B, and Figs. 15C and 15D are perspective views showing a curved state of the light transmission path when the printer head is moved (driven) in the printing device; and

Fig. 16 is a perspective view showing an outer appearance of a hard disc recording and reproducing device including the light transmission module according to the present embodiment;

Fig. 17 is a cross-sectional view showing a schematic configuration of a conventional light transmission module in which wire bonding is used for an electrical connection unit for electrically connecting an electrical wiring and a photoelectric conversion element;

Fig. 18 is a cross-sectional view showing a configuration modified to reduce an optical coupling distance between a film light guide and a light emitting and receiving element in the light transmission module of Fig. 17; and

Fig. 19 is a cross-sectional view showing a configuration modified to have a sealing boundary of a sealing resin portion flat in the light transmission module of Fig. 18.

DETAILED DESCRIPTION

Hereinafter, one embodiment of the present invention will be described with reference to the drawings.

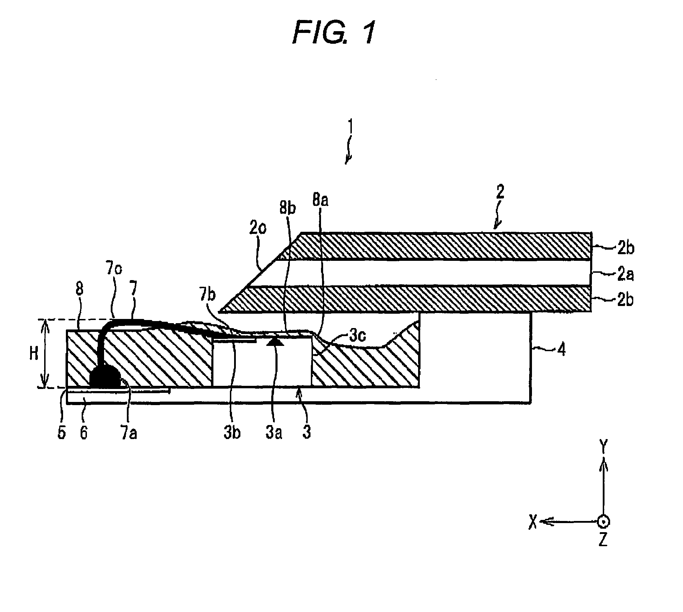

Fig. 1 is a side view showing a schematic configuration of a light transmission module 1 according to the present embodiment. A case in which the light transmission path is the film light guide will be described below, but the light transmission path applicable to the present invention merely needs to be a member having a function of transmitting light, and may be a member such as an optical fiber, optical filter, lens, or cover glass.
The light transmission module 1 includes a film light guide (light transmission path) 2, a light emitting and receiving element (optical element) 3, a height compensation member (seat member) 4, a substrate wiring (electrical wiring) 5, a substrate 6, a bonding wiring 7, and a sealing resin portion (sealing portion) 8.
The film light guide 2 is formed by a core 2a having a large index of refraction and a clad 2b having a small index of refraction arranged contacting the periphery of the core 2a, where the optical signal that entered the core 2a is propagated while repeating total reflection at a boundary of the core 2a and the clad 2b. The film light guide 2 has flexibility since the core 2a and the clad 2b are made of polymeric material having flexibility. Both ends of the film light guide 2 have inclined surfaces of 45 degrees, which inclined surface is a light path conversion mirror 2c for reflecting the optical signal.
On the light exit side in the film light guide 2, the signal light transmitted through the core 2a is reflected by the light path conversion mirror 2c, and exit towards the light emitting and receiving element 3 serving as the light receiving element from the exit surface of the light path conversion mirror 2c with the advancing direction changed. On the light incident side in the film light guide 2, the signal exit from the light emitting and receiving element 3 serving as the light emitting element enters from the incident surface of the light path conversion mirror 2, and then reflected by the light path conversion mirror 2c and transmitted through the core 2a with the advancing direction changed. The exit surface (or incident surface) of light in the film light guide 2 exists at the outer surface of the clad 2b as the light path conversion mirror 2c is arranged, and the light receiving surface (or light emitting surface) of the light emitting and receiving element 3 is arranged to face the exit surface (or incident surface) of light in the film light guide 2.
An angle of the inclined surface of the light path conversion mirror 2c is normally set to 45° so that the alignment of the light path conversion mirror 2c and the light emitting and receiving element 3 is facilitated. However, the angle of the inclined surface of the light path conversion mirror 2c is not limited to 45 degrees in the light transmission module 1, and may be appropriately changed as long as the optical signal that enters can be reflected to the interior of the film light guide 2. Specifically, the angle of the inclined surface of the light path conversion mirror 2c is preferably set in a range of between 35° and 50°. The light path conversion mirror 2c may be configured by externally attaching a mirror to the end of the film light guide 2.

In Fig. 1, at the vicinity of the end of the film light guide 2, the longitudinal direction (optical axis direction) of the light guide 2 is the X-axis direction, and the stacking direction of the core 2a and the clad 2b is the Y-axis direction. The Y-axis direction also coincides with a normal direction of a mounting surface of the film light guide 2 in the substrate 6. Furthermore, a direction perpendicular to the X-axis direction and the Y-axis direction is the Z-axis direction in Fig. 1.

The light emitting and receiving element 3 converts the electric signal to the optical signal, or converts the optical signal to the electric signal, and is mounted on the substrate 6 with a heat curable silver (Ag) paste, and the like. The light emitting and receiving element 3 is a light emitting element such as a laser diode at the light incident side end to the film light guide 2, and is a light receiving element such as a photodiode at the light exit side end from the film light guide 2. The light emitting and receiving element 3 is also a surface light emitting and receiving type element, and is formed with a light emitting and receiving point 3a serving as an active portion for emitting or receiving the optical signal at a surface on the side opposite to the mounting surface to be mounted on the substrate 6. The surface (light emitting and receiving surface) formed with the light emitting and receiving point 3a is formed with an electrode pad 3b electrically connected to the substrate wiring 5.

The height compensation member 4 is a holding member for mounting the film light guide 2 and for maintaining the distance between the film light guide 2 and the light emitting and receiving element 3 constant. The height of the height compensation member 4 is set in advance so that the light coupling efficiency of the film light guide 2 and the light emitting and receiving element 3 becomes optimum.

The substrate wiring 5 connects the light emitting and receiving element 3 and an electronic circuit (not shown) such as a drive circuit to transmit electric signals. Specifically, a flexible print substrate (FPC), a coaxial cable, a lead frame, and the like are known.

The bonding wiring 7 is a wiring for connecting the electrode pad 3b of the light emitting and receiving element 3 and the substrate wiring 5. Of ends 7a and 7b of the bonding wiring 7, the end 7a on the substrate wiring 5 side has a ball-shaped structure. The end 7b on the electrode pad 3b side, on the other hand, does not have a ball-shaped structure. In other words, the electrode pad 3b, the substrate wiring 5, and the wire bonding structure are a reverse wire bonding structure in the light transmission module 1. The "reverse wire bonding structure" referred to herein intends a structure in which a loop-shaped bent portion (portion where tilt greatly changes compared to other regions in the bonding wiring 7 such as bend, curve, and deflect) 7c in the bonding wiring 7 is arranged in the vicinity of the end 7a on the substrate wiring 5 side of the bonding wiring 7 (structure in which bent portion 7c is arranged on the upper side of the end 7a of the bonding wiring 7). Such reverse wire bonding structure can be manufactured by forming the end 7a to a ball-shape and bonding the end 7a to the substrate wiring 5, and then bonding the end 7b to the electrode pad 3b. The manufacturing of the reverse wire bonding structure will be described later.

In the conventional light transmission module, the connection structure of the electrode pad and the substrate wiring is manufactured by forming a contact with the electrode pad, and then forming a contact with the substrate wiring. In other words, "forward wire bonding structure" is adopted as opposed to the "reverse wire bonding structure". Thus, the optical coupling distance of the film light guide and the light emitting and receiving element (light emitting and receiving point) is set to a distance greater than the loop height of the bonding wiring, and hence it is difficult to bring the film light guide and the light emitting and receiving element close.

In the light transmission module 1, the wire bonding structure of the electrode pad 3b and the substrate wiring 5 is a reverse wire bonding structure, and the height of the light emitting and receiving element 3 and a loop height H cancel each other out. In other words, the loop height H of the bonding wiring 7 does not need to be taken into consideration when setting the distance between the film light guide 2 and the light emitting and receiving point 3a. Thus, the film light guide 2 and the light emitting and receiving element 3 can be brought close, and lower height of the light transmission module 1 can be realized.

The loop height H of the bonding wiring 7 is preferably about 60 $\mu$m to have the distance between the film light guide 2 and the light emitting and receiving element 3 as small as possible. The position of the end 7a to be connected to the substrate wiring 5 is the position in the vicinity of the light emitting and receiving element 3, and the length of the bonding wiring 7 is preferably set short to prevent disconnection due to deformation of the bonding wiring 7. For instance, if the height of the light emitting and receiving element 3 is 200 $\mu$m, the distance in the planar direction of the wire connecting portion of the substrate wiring 5 and the wire connecting portion of the light emitting and receiving element 3 is 150 $\mu$m.

One role of the sealing resin portion 8 is to seal the light emitting and receiving element 3 to protect the light emitting and receiving element 3 from dust and humidity, and to enhance the reliability of the optical cable module 1.

In addition, the sealing resin portion 8 also has an action of preventing diffusion of the optical signal transmitted between the film light guide 2 and the light emitting and receiving element 3, and suppressing the optical loss caused by the diffusion of the optical signal. Transparent resin such as epoxy series, acrylic series, silicone series, and urethane series having high index of refraction is suitably used for the material (liquid sealing resin material) configuring the sealing resin portion 8. The index of refraction of the sealing resin portion 8 has effects if the material configuring the sealing resin portion 8 has greater index of refraction than air.

In the light transmission module 1, the sealing resin portion 8 includes an inclined part 8a and a flat part 8b, which parts are coupled to each other. The inclined part 8a is a part where the sealing resin material is raised and solidified along the side wall 3c of the light emitting and receiving element 3 by surface tension. The flat part 8b is a part where the sealing resin material is spread in parallel and solidified along the light emitting and receiving surface.

As hereinafter described, the inclined part 8a is a part generated when the sealing resin material is dropped by potting and solidified between the light emitting and receiving element 3 and the height compensation member 4. The flat part 8b is the part generated when the sealing resin material is dropped by potting and solidified on the light emitting and receiving surface of the light emitting and receiving element 3. When the sealing resin material is dropped between the light emitting and receiving element 3 and the height compensation member 4, the sealing resin material climbs up along the side wall 3c of the light emitting and receiving element 3 by surface tension. When the liquid sealing resin material is dropped on the light emitting and receiving surface of the light emitting and receiving element, the sealing resin material spreads to the edge of the light emitting and receiving element 3 by surface tension. The sealing resin material dropped on the light emitting and receiving surface contacts the sealing resin material climbing up along the side wall 3c of the light emitting and receiving element 3, - and flows into a space between the light emitting and receiving element 3 and the height compensation member 4. As a result, the flat part 8b serving as a solidified object of the sealing resin material dropped on the light emitting and receiving surface becomes a very thin film-shape. Thus, since a thickness of the sealing resin portion 8 that covers the light emitting and receiving surface of the light emitting and receiving element 3 becomes thin, the film light guide 2 and the light emitting and receiving element 3 can be brought sufficiently close. Furthermore, since the flat part 8b is parallel to the light emitting and receiving surface and is not inclined, increase in the light path length due to refraction at the sealing boundary of the light exit from the light emitting and receiving point 3a can be avoided when the distance between the film light guide 2 and the light emitting and receiving element 3 is brought close. As a result, lower height can be realized, and the light transmission module 1 in which the optical coupling loss (optical loss) of the film light guide 2 and the light emitting and receiving element 3 is small can be realized.

The flat part 8b is a part generated when the sealing resin material dropped on the light emitting and receiving surface contacts the sealing resin material climbing up along the side wall 3c of the light emitting and receiving element 3, and flows into the space between the light emitting and receiving element 3 and the height compensation member 4. The thickness (length in Y-direction) of the flat part 8b thus can be set according to the type, the solid state property (viscosity) of the sealing resin material, or the dropping amount of the sealing resin material. If the heat curable silicone resin having a viscosity of between 30 and 8.0 Pa·s is used for the sealing resin material, a thickness of the flat part 8b is between 5 $\mu$m and 20 $\mu$m. In this case, a sealing angle indicating the flatness of the flat part 8b (angle with respect to light emitting and receiving surface of the surface facing the film light guide 2 in the flat part 8b) is between 0° and 1°.

In the configuration of Fig. 1, the sealing resin portion 8 does not fill the entire gap between the film light guide 2 and the light emitting and receiving element 3, and a void is formed between the sealing resin portion 8 and the film light guide 2. In other words, a void is formed between the surface of the sealing resin portion 8 on the light receiving surface or the light emitting surface (light emitting and receiving surface) of the light emitting and receiving element 3, and the exit surface or the incident surface of the film light guide 2. This is because the curing contraction of the sealing resin portion 8 adversely affects the positioning of the film light guide 2 if a structure in which the film light guide 2 contacts the sealing resin portion 8 is adopted.

The sealing resin portion 8 merely needs to be a configuration that seals the light emitting and receiving element 3, and merely needs to cover at least the contacts (ends 7a, 7b) with the substrate wiring 5 and the electrode pad 3b for the bonding wiring 7.

In the light transmission module 1, the loop shape of the bonding wiring 7 is exposed from the sealing resin portion 8. Thus, a configuration in which the sealing resin portion 8 existing between the bonding wiring 7 and the film light guide 2 is reduced is achieved. In the conventional light transmission module, the thickness of the sealing resin portion 8 existing between the bonding wiring 7 and the film light guide 2 is at least between 5 and 20 $\mu$m. In the light transmission module 1, the film light guide 2 and the bonding wiring 7 can be brought close compared to the conventional light transmission module by the reduction of the sealing resin portion 8, and the distance between the film light guide 2 and the light emitting and receiving element 3 can be reduced.

Therefore, the light transmission module 1 has the following configurations (a) and (b). (a) The substrate wiring 5 and the electrode pad 3b are reverse wire-bonded by the bonding wiring 7. (b) The sealing resin portion 8 includes the inclined part 8a where the liquid sealing resin material is raised and solidified along the side wall 3c of the light emitting and receiving element 3 by surface tension and the flat part 3b where the liquid sealing resin material is spread in parallel and solidified along the light emitting and receiving surface, where the inclined part 3a and the flat part 3b are coupled. With such configurations (a) and (b), lower height can be realized, and the light transmission module 1 in which the optical coupling loss (optical loss) of the film light guide 2 and the light emitting and receiving element 3 is small can be realized. The conventional light transmission module and the light transmission module 1 will be described below regarding the result of comparing the estimation of the optical loss.

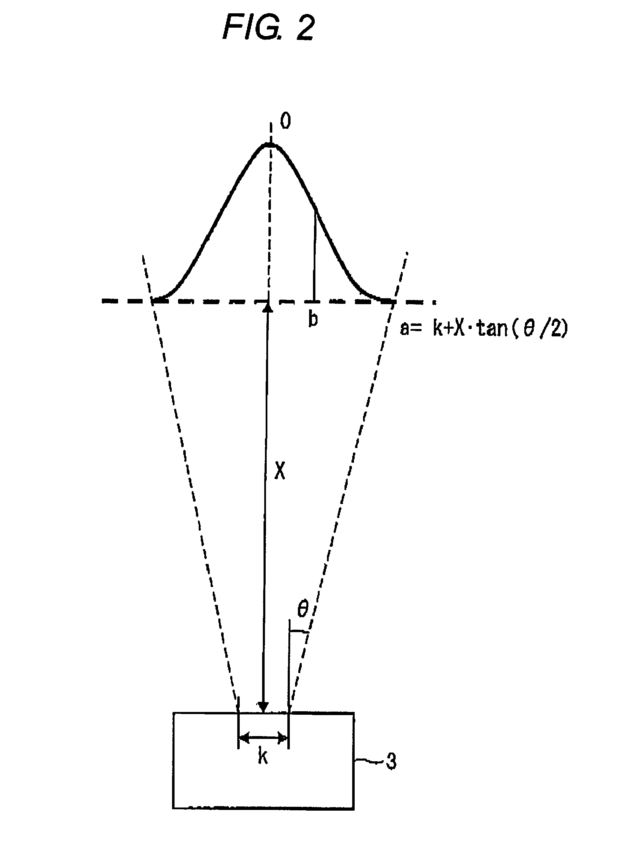

Fig. 2 is a schematic view for describing the way of thinking the estimation of the optical loss. As shown in the figure, assume that the diameter of the light emitting and receiving point of the light emitting and receiving element 3 is k, and a spread angle of the beam exit from the light emitting and receiving point is θ. The intensity distribution of the beam exit from the light emitting and receiving point is Gaussian distribution. The bean intensity at the area spaced apart by b in the perpendicular direction with respect to the optical axis from the beam center O can be expressed with the following equation (1). "a" in equation (1) is the outermost end in the Gaussian distribution (i.e., spaced distance with the beam center O when beam intensity = 0).

$$\frac{1}{a} EXP(-b^2/2a^2) \quad \cdots (1)$$

The distance spaced apart in the optical axis direction from the light emitting and receiving element is X. The beam shape is assumed to be circular. Thus, the in-beam intensity from the beam center O to the distance b in the distance X can be expressed with equation (2) by taking the integral of the intensity distribution of the beam.

$$\int_0^b \left(2\pi X \cdot EXP(-X^2/2a^2)\right) \, dX \quad \cdots (2)$$
$$\Leftrightarrow 2\pi\left(1 - EXP(-b^2/2a^2)\right)$$

From equation (2), X is assumed to change if the sealing surface of the sealing resin portion 8 (surface facing the film light guide 2 in the flat part 8b) is inclined with respect to the light emitting and receiving surface. If inclined in such manner, the optical axis of the exit light shifts due to the refraction at the sealing surface, and the irradiation intensity to the core is assumed to decrease.

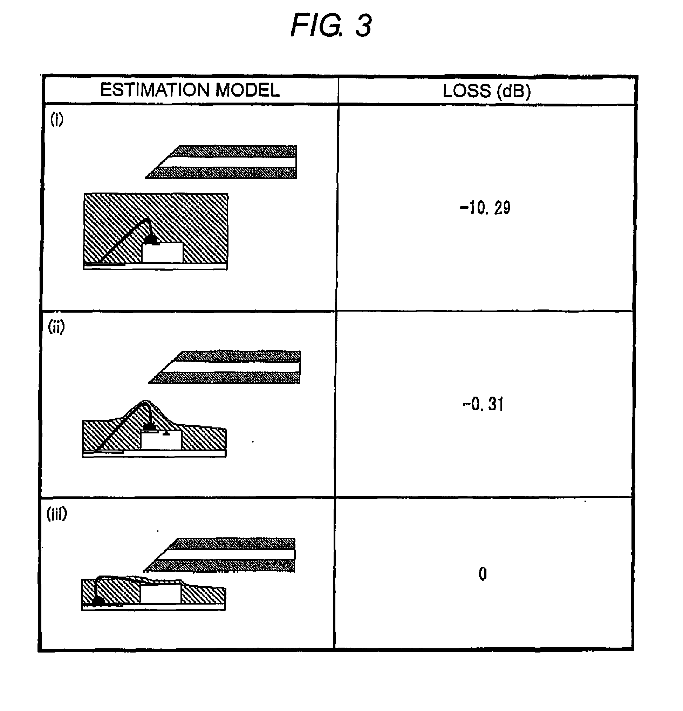

Fig. 3 is a table showing the result of estimating the optical loss based on the way of thinking of the estimation shown in Fig. 2 for the conventional light transmission module and the light transmission module 1, and comparing the estimations. The estimation model of the compared light transmission module is model (i) to (iii). The model (i) is the conventional light transmission module shown in Fig. 17, the model (ii) is the conventional light transmission module shown in Fig. 18, and the model (iii) is the light transmission module 1 of the present embodiment.

Upon estimating the optical loss, the core diameter is 20 μm, the distance between the light receiving element and the film light guide at first is 200 μm, a beam spread angle θ is 15°, and the diameter of the light emitting and receiving point is 10 μm for the models (i) to (iii). With respect to the model (ii), the estimation is carried out with an inclination angle of the sealing surface as 20°, and with a configuration in which the sealing surface high-low difference becomes 30 μm with respect to the sealing surface length of 100 μm. In the model (iii), the estimation is carried out with the inclination angle of the sealing surface as 0°.

As shown in Fig. 3, it can be found that the estimation of the optical loss of the model (i) is -10.29 dB, and the optical loss is increased. It can also be found that the estimation of the optical loss of the model (ii) is -0.31 dB and the optical loss is not increased as much as the model (i), but the optical loss is caused by the inclination of the sealing surface. As opposed to the estimation of the optical loss of the models (i), (ii), the estimation of the optical loss of the model (ii) is 0 dB, and no optical loss is found. From the estimation result of the optical loss shown in Fig. 3, it can be seen that the light transmission module 1 can reduce the optical coupling loss (optical loss) between the film light guide 2 and the light emitting and receiving element 3, compared to the conventional light transmission module.

(Manufacturing method of light transmission module)

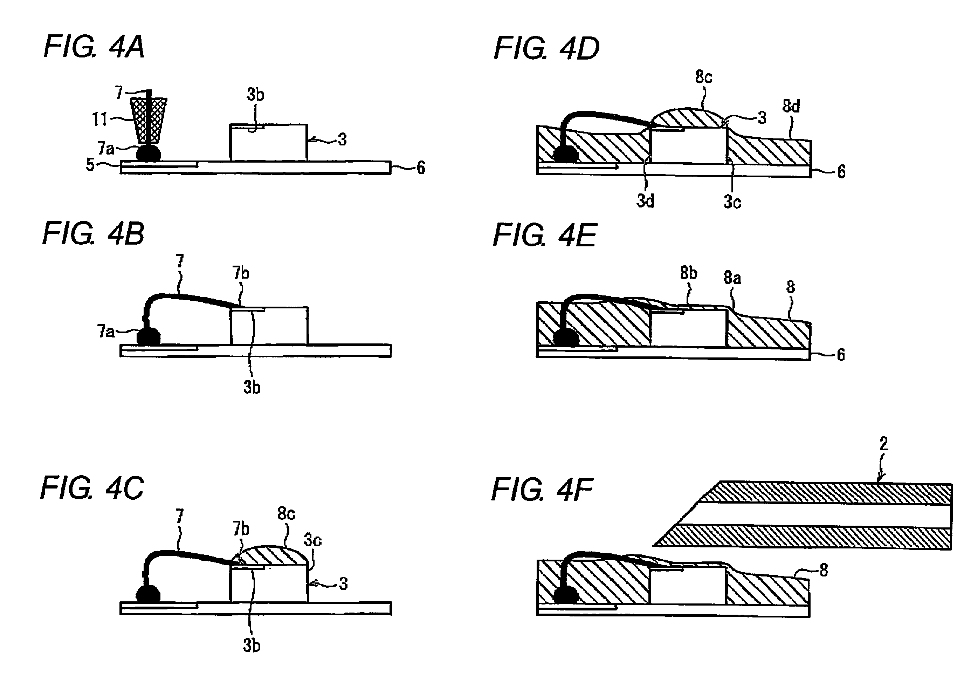

The manufacturing procedures of the light transmission module 1 will be described below with reference to Figs. 4A to 4F. Figs. 4A to 4F are cross-sectional views showing the manufacturing procedures of the light transmission module 1 of the present embodiment.

As shown in Fig. 4A, the bonding wiring 7 is connected to the substrate wiring 6 of the substrate 6 using a capillary 11. First, the bonding wiring 7 is arranged above (upper side in Y-direction) the substrate wiring 6. The bonding wiring 7 is held in a through-hole of the capillary 11, and has the end 7a projecting to the outer side of the capillary 11. The end 7a of the bonding wiring 7 is formed with the ball-shaped structure by discharging high voltage. The end 7a is bonded to the substrate wiring 6 by pressurizing the end 7a of the bonding wiring 7 to the substrate wiring 6. Ultrasonic vibration, heat, and the like may be applied while pressurizing the end 7a to the substrate wiring 6.

Then, as shown in Fig. 4B, the bonding wiring 7 is pulled out in the direction of the electrode pad 3b of the light emitting and receiving element 3, and one part of the bonding wiring 7 and the electrode pad 3b are bonded. In this case as well, ultrasonic vibration, heat, and the like may be applied while pressurizing the bonding wiring 7 to the electrode pad 3b. After the bonding, the capillary 11 is separated from the electrode pad 3b, and the bonding wiring 7 is cut. The bonding wiring 7 for electrically connecting the electrode pad 3b and the substrate wiring 6 is thereby formed to a "reverse wire bonding structure" (bonding step).

Sealing is then performed on the reverse wire bonding structure of the light transmission module 1 fabricated in the above manner. First, as shown in Fig. 4C, the sealing resin material of liquid form (first liquid sealing resin material) 8c is dropped through potting on the light emitting and receiving surface of the light emitting and receiving element 3 (first dropping step). Here, the sealing resin material 8c spreads along the light emitting and receiving surface by surface tension. In the step shown in Fig. 4C, the dropping is stopped at the time point the sealing resin material 8c covers the electrode pad 3b, and reaches the end of the light emitting and receiving element 3 when seen from the light emitting and receiving surface side. In the step shown in Fig. 4C, the sealing resin material 8c is prevented from dropping along the side wall of the light emitting and receiving element 3.

Then, as shown in Fig. 4D, the sealing resin material of liquid form (second liquid sealing resin material) 8d is dropped through potting on the surface of the substrate 6 (second dropping step). In the step shown in Fig. 4D, the region where the sealing resin material 8d is dropped is the surface of the substrate 6 excluding the mounting surface of the light emitting and receiving element 3. Here, the sealing resin material 8d rises and spreads along the side walls 3c, 3d of the light emitting and receiving element 3 by surface tension. In the step shown in Fig. 4D, the dropping is stopped at the time point the sealing resin material 8d that rises along the side walls 3c, 3d of the light emitting and receiving element 3 contacts the sealing resin material 3c positioned at the edge of the light emitting and receiving element 3.

When the sealing resin material 8d that rises along the side walls 3c, 3d of the light emitting and receiving element 3 contacts the sealing resin material 3c, the sealing resin material 8c flows to the surface of the substrate 6 at the periphery of the light emitting and receiving element 3 along the side wall without retaining at the light emitting and receiving surface. When the flow of the sealing resin material 8c to the surface of the substrate 6 is stopped, the sealing resin material 8c is spread in parallel to the light emitting and receiving surface at a minimum liquid amount. The sealing resin portion 8 (i.e., flat part 8b) covering the light emitting and receiving surface can be formed thin and flat by solidifying the sealing resin material 8c spread on the light emitting and receiving surface and the sealing resin material 8d on the substrate 6. Fig. 4E is a cross-sectional view showing a configuration of the light transmission module 1 after the sealing resin materials 8c, 8d are solidified. The flat part 8b in the light transmission module 1 shown in the figure is configured by a solidified object of the sealing resin material 3c spread in parallel to the light emitting and receiving surface at a minimum liquid amount. The liquid amount of the sealing resin material 8d on the surface of the substrate 6 is great due to the flowing of the sealing resin material 8c to the surface of the substrate 6. The inclined part 8a is the portion where the sealing resin material 8d of great liquid amount is raised and solidified by the surface tension with the side wall 3c of the light emitting and receiving element 3. The thickness of the flat part 8b can be controlled by reducing the dropping amount of the sealing resin material 8c or using resin of low viscosity (lower than or equal to 10 Pa.s).

The method of solidifying the sealing resin materials 8c, 8d is not particularly limited as long as it is a method conventionally known as a resin solidifying method (curing method). For instance, a method of thermally curing and solidifying the sealing resin material using an oven and the like, a method of thermally curing and solidifying the sealing resin material using an oven and the like after temporarily curing by ultraviolet ray irradiation, and the like may be adopted.

In the steps shown in Figs. 4C to 4E, the sealing resin materials 8c, 8d do not need to be dropped to completely cover the bonding wiring 7. The sealing resin materials 8c, 8d are to be dropped to cover the ends 7a, 7b of the bonding wiring.

Thereafter, as shown in Fig. 4F, the film light guide 2 is aligned and mounted on the substrate 6, to thereby complete the light transmission module 1. Since a thickness of the flat part 3b that covers the light emitting and receiving surface of the light emitting and receiving element 3 is extremely thin when mounting the film light guide 2, the distance between the film light guide 2 and the light emitting and receiving element 3 can be made sufficiently small.

In the manufacturing procedures shown in Figs. 4A to 4F, the second dropping step of dropping the liquid sealing resin material 8d on the surface of the substrate 6 through potting is performed after the first dropping step of dropping the liquid sealing resin material 8c on the light emitting and receiving surface of the light emitting and receiving element 3 through potting. However, the order of the first and the second dropping steps is not limited to the above order, and merely needs to be an order in which the sealing resin materials 8c, 8d can be contacted to each other by the first and the second dropping steps. For instance, the dropping may be performed until the sealing resin material 8d rises up to the light emitting and receiving surface along the side walls 3c, 3d of the light emitting and receiving element 3 in the second dropping step, and thereafter, the dropping may be stopped at the time point the sealing resin material 8c spread in parallel to the light emitting and receiving surface contacts the sealing resin material 8d in the second dropping step. The first and the second dropping steps may be performed in parallel, and the dropping in both steps may be stopped at the time point the sealing resin materials 8c, 8d contact each other.

(First variant)

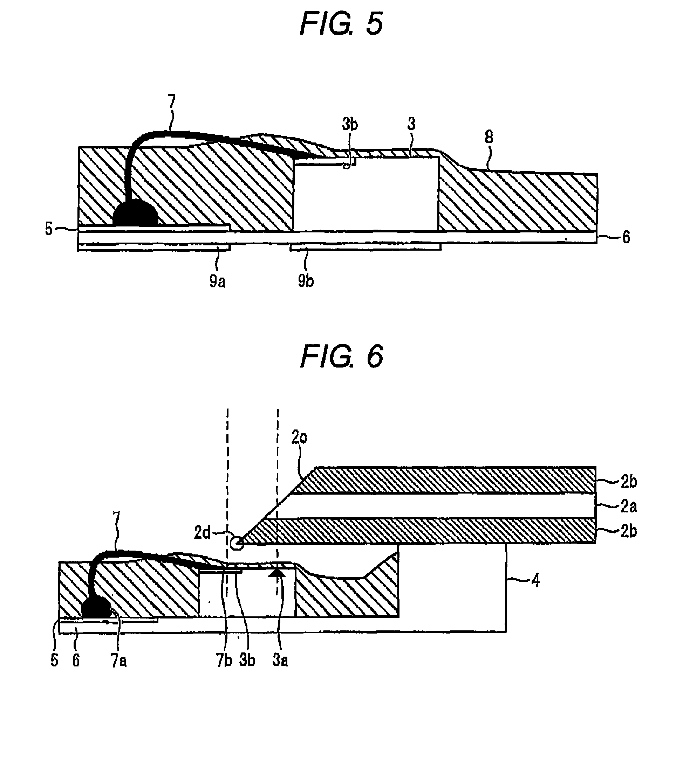

A variant of the configuration shown in Fig. 1 will be described with respect to the configuration of the light transmission module 1 of the present embodiment. Fig. 5 is a cross-sectional view showing a schematic configuration of the light transmission module serving as the first variant. In Fig. 5, the film light guide 2 is omitted to simplify the configuration of the first variant.

As shown in the figure, the light transmission module 1 of the first variant has a configuration including dummy pads 9a and 9b. The dummy pads 9a and 9b are arranged on the mounting surface of the light emitting and receiving element 3 and the surface on the opposite side in the substrate 6. The dummy pad 9a is arranged to overlap with the connecting portion with the bonding wiring 7 of the substrate wiring 5 in plan view. The dummy pad 9b is arranged to overlap with the light emitting and receiving element 3 in plan view.

The light transmission module 1 of the first variant is particularly effective when a substrate in which the substrate wiring 6 is stacked (i.e., flexible print wiring (FPC) substrate) on the film-shaped insulating body is used for the substrate 6.

The ultrasonic vibration is applied to the electrode pad 3b and the substrate wiring 6 when the electrode pad 3b and the substrate wiring 6 are wire-bonded by the bonding wiring. If the substrate 6 is an FPC substrate, the substrate 6 deflects upon application of the ultrasonic vibration. The ultrasonic wave is hard to be transmitted to the electrode pad 3b and the substrate wiring 6 since the rigidity of the substrate 6 itself is small. As a result, problems such as the bonding wiring 7 cannot be connected to be electrode pad 3b and the substrate wiring 6, and the joint strength significantly lowers arise.

In the light transmission module 1 of the first variant, the dummy pads 9a and 9b area arranged on the forming surface of the substrate wiring 6 and the mounting surface of the light emitting and receiving element 3, and the surface on the opposite side in the substrate 6, and thus the deflection of the substrate 6 due to application of the ultrasonic vibration can be suppressed. Furthermore, the rigidity of the wire joining portion of the electrode pad 3b and the substrate wiring 6 can be ensured, and satisfactory joint strength can be realized.

The occupying area of the dummy pads 9a and 9b is at least greater than or equal to the occupying area of the wire joining portion of the electrode pad 3b and the substrate wiring 6. Since the mounting position of the light emitting and receiving element 3 varies, the occupying area of the dummy pad 9b is preferably the same as the mounting area of the light emitting and receiving element 3. For instance, the area of the connecting portion of the bonding wiring 7 in the substrate wiring 5 is

$70 \, \mu m^2$ when wire bonding is carried out using the bonding wiring 7 having a diameter of 20 $\mu$m. In this case, the occupying area of the substrate 6 of the dummy pad 9a becomes greater than or equal to 70 $\mu m^2$.

The material configuring the dummy pads 9a, 9b is a material having higher rigidity than the material configuring the substrate 6. The dummy pads 9a, 9b may have electrical conductivity or may not have electrical conductivity. Thicknesses of the dummy pads 9a, 9b are not particularly limited, but are preferably the same thickness as the substrate 6 to ensure the rigidity of the substrate 6.

(Second variant)

A variant of the configuration shown in Fig. 1 will be described with respect to the configuration of the light transmission module 1 of the present embodiment. Fig. 6 is a cross-sectional view showing a schematic configuration of the light transmission module serving as the second variant.

As shown in the figure, the light transmission module 1 of the second variant has a configuration in which a distal end 2d in the light transmitting direction (X-direction) of the film light guide 2 is arranged between the contact (end 7b) with the electrode pad 3b in the bonding wiring 7 and the light emitting and receiving point 3a. The film light guide 2 includes the light path conversion mirror 2c held by the height compensation member 4 and having at least one end face diagonally processed. The distal end 2d is thus also referred to as a light transmitting direction distal end of the light path conversion mirror 2c.

In the light transmission module 1, a relative position of the core 2a in the light path conversion mirror 3c and the light emitting and receiving point 3a is controlled to realize the optical coupling of the film light guide 2 and the light emitting and receiving element 3. In this control, the core 2a and the light emitting and receiving element 3a do not need to be arranged on the same line perpendicular to the light emitting and receiving surface. The optical coupling can be realized by controlling the relative position of the core 2a and the light emitting and receiving point 3a so that the distal end 2d is positioned between the contact with the electrode pad 3b in the bonding wiring 7 and the light emitting and receiving point 3a.

According to the light transmission module 1 of the second variant, the bonding wiring 7 is reliably prevented from interfering the film light guide 2 since the distal end 2d is arranged between the contact (end 7b) with the electrode pad 3b in the bonding wiring 7 and the light emitting and receiving point 3a. In other words, the film light guide 2 is arranged while reliably avoiding a connecting area of the bonding wiring 7. Thus, the light transmission module 1 in which the distance between the film light guide 2 and the light emitting and receiving element 3 is made sufficiently small and in which the height is lowered can be realized without taking into consideration the height of the wire connecting portion in the electrode pad 3b in addition to the loop height.

The distal end 2d is position adjustable by controlling a thickness of the film light guide 2 and an inclination angle of the light path conversion mirror 2c.

(Third variant)

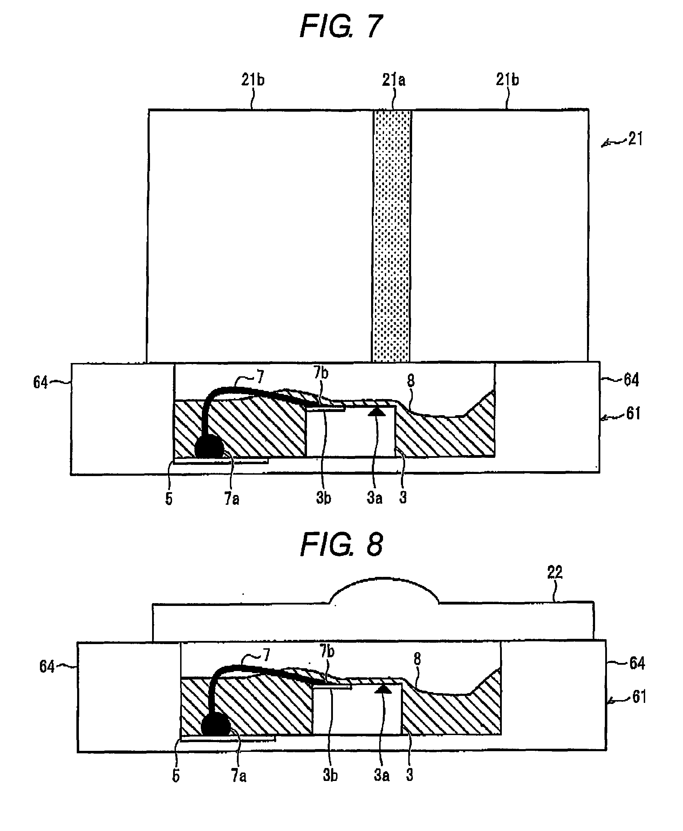

A variant of the configuration shown in Fig. 1 will be described with respect to the configuration of the light transmission module 1 of the present embodiment. As described above, the light transmission path that can be applied to the present invention is not limited to the film light guide, and merely needs to be a member having a function of transmitting light. The light transmission module 1 of the third variant has a configuration including an optical fiber or a lens for the light transmission path. First, Fig. 7 is a cross-sectional view showing a schematic configuration of the light transmission module 1 including the optical fiber for the light transmission path.

As shown in Fig. 7, an optical fiber 21 is formed by a core 21 a having a large index of refraction, and a clad 21 b having a small index of refraction arranged contacting the periphery of the core 21 a. The optical fiber 21 propagates the optical signal that entered the core 21 a while repeating total reflection at the boundary of the core 21 a and the clad 21 b. Both ends of the optical fiber 21 are surfaces cut perpendicular to the light transmitting direction, and the optical signal exit from such surface optically couples with the light emitting and receiving element 3.

The substrate 61 includes two height compensation members 64 for mounting the optical fiber 21 and maintaining the distance between the optical fiber 21 and the light emitting and receiving element 3 constant. The two height compensation members 64 hold ends on both sides in the light transmitting direction of the optical fiber 21.

In the configuration shown in Fig. 7, the distance between the optical fiber 21 and the light emitting and receiving element 3 can be made sufficiently small and lower height of the light transmission module 1 can be realized by appropriately setting the height of the height compensation member 64.

Fig. 8 is a cross-sectional view showing a schematic configuration of the light transmission module 1 including the lens for the light transmission path. The light transmission module 1 shown in the figure is a configuration of the light transmission module 1 in which the optical fiber 21 in Fig. 7 is changed to the lens 22. With this configuration as well, the distance between the lens 22 and the light emitting and receiving element 3 can be made sufficiently small and lower height of the light transmission module 1 can be realized by appropriately setting the height of the height compensation member 64.

A specific example of the light transmission module 1 for implementing the inter-substrate wiring will now be described. Figs. 9A and 9B show the entire light transmission module using the optical wiring serving as the film light guide and the electrical wiring substrate, where Fig. 9A is a top view and Fig. 9B is a side cross-sectional view. As shown in Fig. 9A, the bonding wiring 7 is arranged avoiding the end of the film light guide 2.

In the configuration shown in the figure, one film light guide 2 is arranged on the electrical wiring substrate 6' serving as one substrate 6, and the light emitting and receiving element 3 and height compensation member 4 are arranged in correspondence with the two ends, respectively, of the film light guide 2. The light emitting and receiving element 3 serving as the light emitting element and the light emitting and receiving element 3 serving as the light receiving element are arranged at the position of light emission and the position of light reception, respectively, for the optical signal transmitted by the film light guide 2. The film light guide 2 is fixed on the height compensation member 4 with an adhesive.

The light emitting and receiving element 3 includes the light emitting and receiving point 3a and the electrode pad 3b on the same plane. The film light guide 2 and the light emitting and receiving point 3a of the light emitting and receiving element 3 are optically coupled.

Similar to the configuration shown in Fig. 1, the electrode pad 3b of the light emitting and receiving element 3 and the substrate wiring 5 are reverse wire-bonded by the bonding wiring 7. The role of the sealing resin portion 8 is similar to the configuration shown in Fig. 1, and thus the description will be omitted. The film light guide 2 and the light emitting and receiving element 3 mounted on the electrical wiring substrate 6' are housed in one housing 10.

In the configuration shown in Figs. 9A and 9B, two units including the height compensation member 4 and the light emitting and receiving element 3 are arranged on one substrate 6, but the light transmission module 1 has a configuration in which the units are arranged on separate substrates 6. Figs. 10A and 10B show another example of the light transmission module 1 for implementing the inter-substrate wiring, where Fig. 10A is a top view and Fig. 10B is a side cross-sectional view.

In the configuration shown in the figure, the transmission side substrate 6a and the reception side substrate 6b are arranged as the substrate 6. The film light guide 2 is mounted as a medium for transmitting light between the transmission side substrate 6a and the reception side substrate 6b. The light emitting and receiving element 3 and the height compensation member 4 are arranged on each substrate of the transmission side substrate 6a and the reception side substrate 6b in correspondence to the two ends of the film light guide 2. The film light guide 2 is fixed on the height compensation members 4 with an adhesive. The film light guide 2 and the light emitting and receiving element 3 disposed on each substrate of the transmission side substrate 6a and the reception side substrate 6b are respectively housed in the transmission side housing 10a and the reception side housing 10b.

Figs. 11A and 11B show another further example of the light transmission module for implementing the inter-substrate wiring, where Fig. 11A is a top view and Fig. 11B is a side cross-sectional view.

The light transmission module 1 shown in Figs. 11A and 11B has a configuration in which a unit including the height compensation member 4 and a unit including the light emitting and receiving element 3 are respectively arranged on different substrates 6. The height compensation member 4 is arranged as a container surrounding the periphery of the light emitting and receiving element 3 and accommodating the light emitting and receiving element 3. In the case of such configuration, a member for connecting an external wiring substrate 31 A and a wiring substrate 31 B is only the film light guide 2. Thus, even if the wiring substrate 31 A and 31 B are not on the same plane, the degree of freedom of the path for connecting the wiring substrates can be enhanced by using the flexibility of the film light guide 2. The electrical connecting portion 5a is arranged on the outer side surface of the height compensation member 4. The external wiring substrates 31 A and 31B respectively include the connection holding member 32A and 32B, and the electrical connecting portion 33A and 33B. When such external wiring substrates 31A and 31 B are connected to the light transmission module 1, the external wiring substrates 31A and 31 B can be signal connected by light transmission.

In the configuration shown in Figs. 11A and 11B, the degree of freedom of the connection path of the wiring substrate 31 A and the wiring substrate 31 B can be enhanced by configuring the substrate 6 by a flexible substrate. However, if the substrate 6 and the film light guide 2 are arranged between the two wiring substrates 31 A and 31 B, the substrate 6 and the film light guide 2 may physically interfere with each other thereby limiting the degree of freedom of the path, where the degree of freedom of the path can be further enhanced since such interference does not occur if the wiring substrates are connected with only the film light guide 2.

The electrical connecting portion 5a may be arranged in a shape projecting out in a direction parallel to the surface of the substrate 7. This configuration is shown in Figs. 12A and 12B. According to such configuration, the external wiring substrates 31A and 31 B and the light transmission module 1 are electrically connected by being brought close in the direction parallel to the respective substrate surfaces, and disconnected by being moved apart in the opposite direction.

In the configuration shown in Figs. 12A and 12B, the electrical connecting portion 5a may be an electrical connector arranged on the surface on the side opposite to the light emitting and receiving element 3 of the substrate 6. This configuration is shown in Figs. 13A and 13B. According to such configuration, the light transmission module 1 is electrically connected with the external wiring substrates 31 A and 31 B by being brought close in the direction perpendicular to the substrate surface, and disconnected by being moved apart in the opposite direction. In the configuration shown in Figs. 13A and 13B, the height compensation member 4 may include side walls surrounding the light emitting and receiving element 3. In this configuration, the light emitting and receiving element 3 is arranged in an opening formed by the side walls of the height compensation member 4. The sealing resin may be injected to the opening formed by the side walls of the height compensation member 4.

(Application example)

The light transmission module 1 including the film light guide can be applied to the following application examples.

First, as a first application example, use can be made at a hinge portion in a foldable electronic device such as a foldable portable telephone, a foldable PHS (Personal Handyphone System), a foldable PDA (Personal Digital Assistant), and a foldable notebook computer.

Figs. 14A to C show an example in which the film light guide 204 is applied to a foldable portable telephone 140. In other words, Fig. 14A is a perspective view showing an outer appearance of the foldable portable telephone 140 incorporating the film light guide 204.

Fig. 14B is a block diagram of a portion where the light guide 10 is applied in the foldable portable telephone 140 shown in Fig. 14A. As shown in the figure, a control unit 141 arranged on a body 140a side in the foldable portable telephone 140, an external memory 142, a camera (digital camera) 143, and a display unit (liquid crystal display) 144 arranged on a lid (drive portion) 140b side rotatably arranged at one end of the body with the hinge portion as a shaft are connected by the film light guide 204.

Fig. 15C is a perspective plan view of the hinge portion (portion surrounded with a broken line) in Fig. 15A. As shown in the figure, the film light guide 204 is wrapped around a supporting rod at the hinge portion and bent to thereby connect the control unit arranged on the body side, and the external memory 142, the camera 143, and the display unit 144 arranged on the lid side.

High speed and large capacity communication can be realized in a limited space by applying the film light guide 204 to the foldable electronic device. Therefore, it is particularly suitable in devices where high speed and large capacity data communication is necessary and miniaturization is demanded such as the foldable liquid crystal display.

As a second application example, the film light guide 2 is applied to a device having a drive portion such as a printer head in a printing device (electronic device) and a reading unit in a hard disk recording and reproducing device.

Figs.16A to C show an example in which the film light guide 2 is applied to a printing device 50. Fig. 16A is a perspective view showing an outer appearance of the printing device 50. As shown in Fig. 16A, the printing device 50 includes a printer head 51 for performing printing on a paper 52 while moving in a width direction of a paper 52, where one end of the film light guide 2 is connected to the printer head 51.

Fig. 16C is a block diagram of a portion where the film light guide 2 is applied in the printing device 50. As shown in the figure, one end of the film light guide 2 is connected to the printer head 51, and the other end is connected to a body side substrate in the printing device 50. The body side substrate includes control means etc. for controlling the operation of each unit of the printing device 50, and the like.

Figs. 16C and 16D are perspective views showing a curved state of the film light guide 2 when the printer head 51 is moved (driven) in the printing device 50. As shown in the figures, when the film light guide 2 is applied to the drive portion such as the printer head 51, the curved state of the film light guide 2 changes by the drive of the printer head 51 and each position of the film light guide 2 repeatedly curves.

Therefore, the light transmission module 1 according to the present embodiment is suited for such a drive portion. High speed and large capacity communication using the drive portion can be realized by applying the light transmission module 1 to such drive portions.

Fig. 17 shows an example in which the film light guide 304 is applied to a hard disk recording and reproducing device 60.

As shown in the figure, the hard disk recording and reproducing device 160 includes a disk (hard disk) 161, a head (read/write head) 162, a substrate introducing portion 163, a drive portion (drive motor) 164, and the film light guide 304.

The drive portion 164 drives the head 162 along a radial direction of the disk 161. The head 162 reads the information recorded on the disk 161 and writes information on the disk 161. The head 162 is connected to the substrate introducing portion 163 by way of the film light guide 304, and propagates the information read from the disk 161 to the substrate introducing portion 163 as a light signal and receives the light signal of the information to write to the disk 161 propagated from the substrate introducing portion 163.

Therefore, high speed and large capacity communication can be realized by applying the film light guide 304 to the drive portion such as the head 162 in the hard disk recording and reproducing device 160.

The present invention is not limited to the above-described embodiments, and various modifications may be made within the scope of the Claims. In other words, the embodiments obtained by combining the technical means appropriately modified within the scope of the Claims are encompassed in the technical scope of the present invention.

The light transmission module according to the present invention is applicable to the light communication path between various types of devices, and is also applicable to a flexible optical wiring serving as an in-device wiring mounted in a small and thin commercial-off-the-shelf device.

## Claims

1. A light transmission module (1) comprising:

   a light transmission path (2) for transmitting light;
   an optical element (3) including a light emitting and receiving surface for emitting or receiving an optical signal transmitted by the light transmission path, and including a light emitting and receiving point (3a) with a function of photoelectric conversion and an electrode pad (3b) formed on the light emitting and receiving surface;
   a substrate (6) supporting the optical element (3) and an electrical wiring (5);
   a bonding wiring (7) for electrically connecting the electrode pad (3b) and the electrical wiring (5); and
   a sealing portion (8) for sealing the optical element (3); wherein
   the electrical wiring (5) and the electrode pad (3b) are reverse wire-bonded by the bonding wiring (7); and
   the sealing portion (8) includes an inclined part (8a) where a liquid sealing resin material is raised and solidified along a side wall of the optical element (3) by surface tension, and a flat part (8b) where the liquid sealing resin material is spread in parallel and solidified along the light emitting and receiving surface, the inclined part (8a) and the flat part (8b) being coupled together.

2. The light transmission module (1) according to claim 1, wherein
   the bonding wiring (7) has a loop shape in which a bent portion is arranged on the electrical wiring side; and
   the sealing portion (8) is formed to cover a respective contact with the electrical wiring (5) and the electrode pad (3b) in the bonding wiring (7) and to expose the portion of the loop shape.

3. The light transmission module (1) according to claim 1, wherein
   the light transmission path (2) is a film light guide in which at least one end face is diagonally processed;
   the bonding wiring (7) is arranged avoiding the light transmission path (2) in plan view; and
   a distal end (2d) in the light transmitting direction of the light transmission path (2d) is arranged between the contact with the electrode pad (3b) in the bonding wiring (7) and the light emitting and receiving point (3a).

4. An electronic device (140; 50; 160) comprising the light transmission module (1) according to claim 1, wherein
the optical element serving as a light emitting element and the optical element serving as a light receiving element are arranged at a position of emitting light and a position of receiving light, respectively, with respect to the optical signal transmitted by the light transmission path (204; 304); and
the light transmission module (1) further includes an electrical connecting portion, electrically connected with the electrical wiring, for electrically connecting with an external wiring.

5. The electronic device (140; 50; 160) according to claim 4, wherein the electrical connecting portion at both ends in the light transmission path (204; 304) is connected to a device substrate inside the electronic device (140), respectively.

6. The electronic device (140; 50; 160) according to claim 4, wherein the optical element and the end face of the light transmission path in the light transmission module are arranged in a housing of the electronic device.

7. The electronic device (140) according to claim 4, wherein
a hinge portion is arranged; and
the light transmission module is arranged at the hinge portion.

8. A manufacturing method of a light transmission module (1) including,
a light transmission path (2) for transmitting light;
an optical element (3) including a light emitting and receiving surface for emitting or receiving an optical signal transmitted by the light transmission path (2), and including a light emitting and receiving point (3a) with a function of photoelectric conversion and an electrode pad (3b) formed on the light emitting and receiving surface;
a substrate (6) supporting the optical element (3) and an electrical wiring (5);
a bonding wiring (7) for electrically connecting the electrode pad (3b) and the electrical wiring (5); and
a sealing portion (8) for sealing the optical element (3); the method comprising the steps of:

bonding step of reverse bonding the electrical wiring (5) and the electrode pad (3b) by the bonding wiring (7);
first dropping step of dropping a first liquid sealing resin material (8c) onto the light emitting and receiving surface of the optical element (3); and

second dropping step of dropping a second liquid sealing resin (8d) material onto the surface of the substrate (6); wherein
dropping is performed until the first liquid sealing resin material (8c) spread by surface tension with the light emitting and receiving surface and the second liquid sealing resin material (8d) raised along a side wall by surface tension with the side wall of the optical element (3) contact in at least one step of the first or the second dropping step.

9. The manufacturing method of the light transmission module (1) according to claim 8, wherein
in the first dropping step, the dropping is stopped at a time point the first liquid sealing resin material (8c) reached an edge of the optical element (3) when seen from the light emitting and receiving surface side; and
in the second dropping step, the dropping is stopped at a time point the second liquid sealing resin material (8d) raised along the side wall of the optical element (3) contacts the first liquid sealing resin material (8c).

FIG. 1

# FIG. 2

$a= k+X \cdot \tan(\theta/2)$

# FIG. 3

| ESTIMATION MODEL | LOSS (dB) |
|---|---|
| (i) | -10. 29 |
| (ii) | -0. 31 |
| (iii) | 0 |

EP 2 224 271 A2

FIG. 4A

FIG. 4D

FIG. 4B

FIG. 4E

FIG. 4C

FIG. 4F

## FIG. 5

## FIG. 6

## FIG. 7

21b      21a      21b

21

64          7    7b    8     64

61

5   7a    3b   3a   3

## FIG. 8

22

64      7   7b    8     64

61

5   7a    3b   3a   3

## FIG. 9A

## FIG. 9B

EP 2 224 271 A2

*FIG. 10A*

*FIG. 10B*

23

# FIG. 11A

# FIG. 11B

EP 2 224 271 A2

## FIG. 12A

## FIG. 12B

FIG. 13A

FIG. 13B

## FIG. 14A

140

140b

140a

## FIG. 14C

142

204

141

## FIG. 14B

140

144

143

142

140b

204 — 204

140a

141

*FIG. 15A*

*FIG. 15B*

BODY SIDE SUBSTRATE 53

PRINTER HEAD

*FIG. 15C*

*FIG. 15D*

## FIG. 16

## FIG. 17

FIG. 18

FIG. 19

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004006689 A
- JP 2005101249 A

- JP 2003066282 A